# EUROPÄISCHE PATENTSCHRIFT

(11) **EP 4 445 413 B1**
(45) Veröffentlichungstag und Bekanntmachung des Hinweises auf die Patenterteilung: **04.02.2026**
(21) Anmeldenummer: 22801784.4
(22) Anmeldetag: 13.10.2022
(51) Int. Cl.: H01L 23/44, H01L 25/07, H01L 25/065, H05K 7/20, H01L 23/473, H01L 23/00

(54) **FLÜSSIGKEITSGEKÜHLTES ELEKTRONISCHES BAUELEMENT**
LIQUID-COOLED ELECTRONIC COMPONENT
COMPOSANT ÉLECTRONIQUE REFROIDI PAR LIQUIDE

(30) Priorität: 10.12.2021 DE 102021214136
(43) Veröffentlichungstag der Anmeldung: 16.10.2024
(73) Patentinhaber: Schaeffler Technologies AG & Co. KG, 91074 Herzogenaurach (DE)
(72) Erfinder: ROSSBACH, Tim, 80687 München (DE); KAPPES, Christian, 80687 München (DE); SCHMALZL, Stefan, 80687 München (DE)
(74) Vertreter: Schaeffler Technologies
(86) Internationale Anmeldenummer: PCT/EP2022/078538
(87) Internationale Veröffentlichungsnummer: WO 2023/104378

(56) Entgegenhaltungen:
- EP-A1- 1 316 999
- US-A- 5 168 348

## Beschreibung

Die vorliegende Erfindung betrifft ein flüssigkeitsgekühltes elektronisches Bauelement, insbesondere ein flüssigkeitsgekühltes elektronisches Hochleistungsbauelement.

Elektronische Bauteile, wie bspw. MOSFETs oder dergleichen, produzieren üblicherweise Wärme im Betrieb. Diese Wärme gilt es abzuführen, um einerseits die Funktionsfähigkeit des elektronischen Bauteils zu gewährleisten und das elektronische Bauteil vor einer Überhitzung zu schützen. Andererseits sollen benachbart angeordnete elektronische Bauteile durch die entstehende Wärme nicht in Mitleidenschaft gezogen werden.

Zur Abfuhr der Wärme werden elektronische Bauteile üblicherweise auf einem Kühlkörper montiert. Der Kühlkörper dient dazu, die beim Betrieb des Bauteils erzeugte Wärme abzuführen.

Ein anderer Ansatz der Wärmeabfuhr besteht darin, das elektronische Bauteil in eine dafür geeignete Kühlflüssigkeit einzutauchen. Eine derartige Tauchkühlung hat den Vorteil, dass mehr Wärme abgeführt werden kann, weil das gesamte elektronische Bauteil mit Kühlflüssigkeit umspült ist.

Das Dokument EP 1 316 999 A1 offenbart ein Verfahren zum Kontaktieren von einem oder mehreren Leistungselektronik-Bauelementen mit Leiterbahnen auf einem Träger mithilfe einer Kontaktvorrichtung mit mehreren flächigen durch Stege zusammenhängenden Kontaktelementen.

Das Dokument US 5 168 348 A offenbart einen Kühlkörper, um Wärme von einer Anordnung von Computerchips in einem elektrischen Modul abzuleiten.

Aufgabe der vorliegenden Erfindung ist es, ein flüssigkeitsgekühltes elektronisches Bauelement bereitzustellen, dass sich durch eine verbesserte Wärmeabfuhr auszeichnet.

Diese Aufgabe wird durch den Gegenstand des Patentanspruchs 1 gelöst. Weitere Ausgestaltungen der vorliegenden Erfindung sind Gegenstand der Unteransprüche.

Das erfindungsgemäße flüssigkeitsgekühlte elektronische Bauelement umfasst ein Substrat (bspw. eine Leiterplatte), einen auf dem Substrat angebrachten ersten Halbleiterbauelementabschnitt und einen auf dem Substrat angebrachten und von dem ersten Halbleiterbauelementabschnitt beabstandet angeordneten zweiten Halbleiterbauelementabschnitt. Die Halbleiterbauelementabschnitte können Abschnitte von separaten Halbleiterbauelementen sein, also bspw. Abschnitte von einem ersten Halbleiterbauelement und einem zweiten Halbleiterbauelement. Die Halbleiterbauelementabschnitte können aber auch zwei voneinander beabstandete Abschnitte ein und desselben Halbleiterbauelements sein. Das erfindungsgemäße flüssigkeitsgekühlte elektronische Bauelement umfasst weiter eine Kühlflüssigkeitsversorgungseinrichtung zur Versorgung des ersten Halbleiterbauelementabschnitts und des zweiten Halbleiterbauelementabschnitts mit Kühlflüssigkeit, wobei die Kühlflüssigkeit dielektrisch ist, um einen Kurzschluss zu vermeiden. Die Kühlflüssigkeitsversorgungseinrichtung gibt eine Hauptströmungsrichtung der Kühlflüssigkeit vor, also eine Richtung, in der die Kühlflüssigkeit hauptsächlich strömt. Das erfindungsgemäße flüssigkeitsgekühlte elektronische Bauelement weist ferner ein Verbindungselement auf, das den ersten Halbleiterbauelementabschnitt und den zweiten Halbleiterbauelementabschnitt elektrisch miteinander verbindet bzw. kontaktiert. Das Verbindungselement kann beispielsweise eine gebogene Form aufweisen, sodass das Verbindungselement in einer Art Bogenform die beiden Halbleiterbauelementabschnitte miteinander elektrisch verbindet. Im erfindungsgemäßen elektronischen Bauelement weist nun das Verbindungselement, also dasjenige Element, das die elektrische Verbindung zwischen den beiden Halbleiterbauelementabschnitten herstellt, ein zusätzliches Strömungsstörungselement auf, das zumindest teilweise die Hauptströmungsrichtung der Kühlflüssigkeit kreuzt.

Das erfindungsgemäße Bauelement beruht zumindest teilweise auf der Erkenntnis, dass ein am Verbindungselement (bspw. ein Bond) ausgebildetes Strömungsstörungselement, das seinerseits die Hauptströmungsrichtung der Kühlflüssigkeit kreuzt, das Strömungsverhalten der Kühlflüssigkeit hinsichtlich einer Wärmeübertragung positiv beeinflussen kann. Die Störung des Strömungsverhaltens der Kühlflüssigkeit beruht einerseits darauf, dass die Kühlflüssigkeit mittels des Strömungsstörungselements letztlich in eine vorbestimmte Richtung umgelenkt bzw. geführt wird, sodass das Strömungsstörungselement im Sinne eines Strömungsführungselements wirkt. Die Störung des Strömungsverhaltens der Kühlflüssigkeit beruht andererseits aber auch darauf, dass zumindest lokal im Bereich des Strömungsstörungselements die Turbulenz der Kühlflüssigkeitsströmung erhöht wird. Beide Effekte, also ein gezieltes Führen der Kühlmittelströmung wie auch eine Änderung der lokalen Turbulenz der Kühlflüssigkeitsströmung, bewirken eine Verbesserung einer Wärmeübertragung von den beiden Halbleiterbauelementabschnitten zur Kühlflüssigkeit. Das Vorhandensein des Strömungsstörungselements am Verbindungselement führt zudem dazu, dass das Verbindungselement letztlich zwei Effekte hat. Einerseits hat das Verbindungselement den Effekt, die beiden Halbleiterbauelementabschnitte elektrisch zu verbinden bzw. zu kontaktieren. Andererseits hat das Verbindungselement im erfindungsgemäßen Bauelement den zusätzlichen Effekt, den Wärmeübergang zwischen den Halbleiterbauelementen und der Kühlflüssigkeit mittels des Strömungsstörungselements positiv zu beeinflussen. Dadurch wird ein vergleichsweise einfaches flüssigkeitsgekühltes elektronisches Bauelement geschaffen, das durch geringe Veränderungen an der Geometrie des Verbindungselements eine verbesserte Wärmeabfuhr gegenüber bekannten flüssigkeitsgekühlten elektronischen Bauelementen aufweist.

Besonders vorteilhaft ist es, wenn das Strömungsstörungselement mit dem Verbindungselement einstückig ausgebildet ist. Das Strömungsstörungselement kann insbesondere durch Umformen das Verbindungselements, beispielsweise durch ein Eindrücken oder Umbiegen des Verbindungselements, gebildet sein. Das Eindrücken oder Umbiegen des Verbindungselements ist dabei derart, dass der eingedrückte oder umgebogene Teil des Verbindungselements letztlich das Strömungsstörungselement bildet. Denkbar ist aber auch, dass das Strömungsstörungselement durch teilweises Ausstanzen oder Ausschneiden und anschließendes Umbiegen des teilweise ausgestanzten oder ausgeschnittenen Teils des Verbindungselements gebildet wird. Viele weitere durch Umformen des Verbindungselements erzeugte Strömungsstörungselemente sind denkbar.

Weiter vorteilhaft ist es, wenn das Verbindungselement im Bereich des Strömungsstörungselements verbreitert ausgebildet ist, um eine vom Verbindungselement zu erfüllende, vorbestimmte Stromtragfähigkeit zu gewährleisten. Insbesondere wenn das Strömungsstörungselement beispielsweise durch Ausnehmungen, lokale Unterbrechungen, Schnitte oder Stanzabschnitte im Verbindungselement erzeugt wird, ergeben sich Unterbrechungen im Verbindungselement, die die Stromtragfähigkeit des Verbindungselements beeinflussen können. Die bevorzugte Ausgestaltung sieht daher vor, dass insbesondere im Bereich derartiger Ausnehmungen das Verbindungselement verbreitert ausgebildet ist, sodass die vorbestimmte Stromtragfähigkeit, die das Verbindungselement zu erfüllen hat, trotz dieser Unterbrechungen erfüllt werden kann.

Eine weitere bevorzugte Ausgestaltung sieht vor, dass das Verbindungselement zusammen mit dem ersten Halbleiterbauelementabschnitt und dem zweiten Halbleiterbauelementabschnitt einen Kühlflüssigkeitskanal bildet. Der Kühlflüssigkeitskanal kann beispielsweise durch eine gebogene Form des Verbindungselements zusammen mit den beiden Halbleiterbauelementabschnitten und gegebenenfalls dem Substrat gebildet werden. Der Kühlflüssigkeitskanal dient zum Führen zumindest eines Teils der zur Versorgung der beiden Halbleiterbauelementabschnitte bereitgestellten Kühlflüssigkeit über die beiden Halbleiterbauelementabschnitte. Das am Verbindungselement ausgebildete Strömungsstörungselement kann zumindest teilweise in den Kühlflüssigkeitskanal hineinragen und/oder aus dem Kühlflüssigkeitskanal herausragen. Insbesondere wenn das Strömungsstörungselement zumindest teilweise aus dem Kühlflüssigkeitskanal herausragt, ist es vorteilhaft, wenn das Strömungsstörungselement zumindest derart herausragt, dass eine außerhalb des Kühlflüssigkeitskanals vorhandene Kühlflüssigkeitsströmung zumindest teilweise in den Kühlflüssigkeitskanal hineingelenkt wird. Diese besonders bevorzugte Ausgestaltung beruht zumindest teilweise auf der Erkenntnis, dass die außerhalb des Kühlflüssigkeitskanals vorbeiströmende Kühlflüssigkeit durch das aus dem Kühlflüssigkeitskanal herausragende Strömungsstörungselement zumindest teilweise in den Kühlflüssigkeitskanal hineingelenkt wird und dadurch zumindest lokal der durch die Kühlflüssigkeitskanal strömende Massen-/Volumenstrom der Kühlflüssigkeit erhöht wird. Zudem ist denkbar, dass ein Abschnitt des Strömungsstörungselements zumindest teilweise aus dem Kühlflüssigkeitskanal herausragt und ein anderer Abschnitt des Strömungsstörungselements zumindest teilweise in den Kühlflüssigkeitskanal hineinragt.

Weiter ist es denkbar, dass sich das Verbindungselement zwischen dem ersten Halbleiterbauelementabschnitt und dem zweiten Halbleiterbauelementabschnitt bogenförmig erstreckt. Dadurch wird ein bogenförmiger Kühlflüssigkeitskanal geschaffen. Das Strömungsstörungselement kann dabei am Verbindungselement mittig zwischen den beiden Halbleiterbauelementabschnitten angeordnet sein. Wenn die Bogenform eine Kreisbogen-Form ist, führt das dazu, dass das Strömungsführungselement an einem Ort des Verbindungselements ausgebildet ist, der letztlich die größte Entfernung zu den Halbleiterbauelementabschnitten bzw. dem Substrat aufweist. Die mittige Anordnung des Strömungsstörungselements hat zudem den Effekt, dass ein vergleichsweise symmetrisches Strömungsprofil im Inneren des Kühlflüssigkeitskanals eingestellt werden kann.

In einer weiteren bevorzugten Ausgestaltung ist vorgesehen, dass das Strömungsstörungselement in Richtung der Hauptströmungsrichtung der Kühlflüssigkeit betrachtet mittig am Verbindungselement angeordnet ist. Alternativ oder zusätzlich kann das Strömungsstörungselement in Richtung der Hauptströmungsrichtung der Kühlflüssigkeit betrachtet auch an seitlichen Randbereichen des Verbindungselements angeordnet sein, je nachdem was für den jeweiligen Anwendungsfall zweckmäßiger ist.

Eine weitere bevorzugte Ausgestaltung sieht vor, dass das Strömungsstörungselement aus mehreren Strömungsstörungsabschnitten ausgebildet ist. Diese Strömungsstörungsabschnitte sind untereinander beabstandet angeordnet und können am Verbindungselement verteilt angeordnet sein. So ist es beispielsweise denkbar, dass mehrere Strömungsstörungsabschnitte des Strömungsstörungselements entlang der Bogenform des Verbindungselements und/oder mittig und/oder in seitlichen Randbereichen des Verbindungselements ausgebildet sind.

Eine weitere bevorzugte Ausgestaltung sieht vor, dass das flüssigkeitsgekühlte elektronische Bauelement neben dem bereits beschriebenen (ersten) Verbindungselement mindestens ein weiteres Verbindungselement aufweist, dass die beiden Halbleiterbauelementabschnitte ebenfalls elektrisch miteinander verbindet. Das mindestens eine, weitere Verbindungselement ist in Hauptströmungsrichtung der Kühlflüssigkeit betrachtet derart benachbart zum ersten Verbindungselement angeordnet, dass die mindestens zwei Verbindungselemente den bereits beschriebenen Kühlflüssigkeitskanal in Richtung der Hauptströmungsrichtung der Kühlflüssigkeit verlängern.

Das weitere Verbindungselement weist nun seinerseits ein weiteres Strömungsstörungselement auf, das ebenfalls zumindest teilweise die Hauptströmungsrichtung der Kühlflüssigkeit kreuzt. Das weitere Strömungsstörungselement kann dabei eine oder mehrere der bereits beschriebenen Ausgestaltungen des Strömungsstörungselements des ersten Verbindungselements aufweisen. So kann beispielsweise auch das weitere Strömungsstörungselement durch Umformen des weiteren Verbindungselements gebildet sein; kann das weitere Verbindungselement im Bereich des weiteren Strömungsstörungselements verbreitert ausgebildet sein; kann das weitere Strömungsstörungselement in den Kühlflüssigkeitskanal hinein- und/oder hinausragen; kann das weitere Strömungsstörungselement mittig zwischen den beiden Halbleiterbauelementabschnitten angeordnet sein, insbesondere wenn sich das weitere Verbindungselement zwischen den beiden Halbleiterbauelementabschnitten bogenförmig erstreckt; kann das weitere Strömungsstörungselement in Richtung der Hauptströmungsrichtung der Kühlflüssigkeit betrachtet mittig und/oder an seitlichen Randbereichen des weiteren Verbindungselements angeordnet sein; und/oder kann das weitere Strömungsstörungselement aus mehreren Strömungsstörungsabschnitten ausgebildet sein, die untereinander beabstandet und verteilt am weiteren Verbindungselement angeordnet sind.

Besonders vorteilhaft ist es, wenn bei zwei Verbindungselementen das Strömungsstörungselement des ersten Verbindungselements und das Strömungsstörungselement des zweiten Verbindungselements die Hauptströmungsrichtung der Kühlflüssigkeit in entgegengesetzte Richtungen kreuzen. Mit anderen Worten ist das erste Stromstörungselement beispielsweise derart ausgebildet, dass es zumindest teilweise in den Kühlflüssigkeitskanal hineinragt, während das zweite Strömungsstörungselement derart ausgebildet ist, dass es zumindest teilweise aus dem Kühlflüssigkeitskanal herausragt. Dadurch entsteht zwischen den beiden Verbindungselementen im Bereich benachbarter Strömungsstörungselemente eine Art Sog bzw. Einsaugwirkung, die eine Strömung der Kühlflüssigkeit in den Kühlflüssigkeitskanal hineinsaugt. Die beiden Strömungsführungselemente können dabei an einander zugewandten Randbereichen des jeweiligen Verbindungselements angeordnet sind.

Weitere vorteilhafte Ausgestaltungen des erfindungsgemäßen Bauelements werden dem Fachmann durch Ausüben der vorliegenden Lehre und Betrachten der beiliegenden Zeichnungen ersichtlich. Es zeigen:
FIG 1 eine schematische Ansicht von Ausgestaltungen des erfindungsgemäßen flüssigkeitsgekühlten elektronischen Bauelements und
FIG 2 eine schematische Schnittansicht von FIG 1.

Elemente gleicher Funktion oder Konstruktion sind figurenübergreifend mit den gleichen Bezugszeichen versehen.

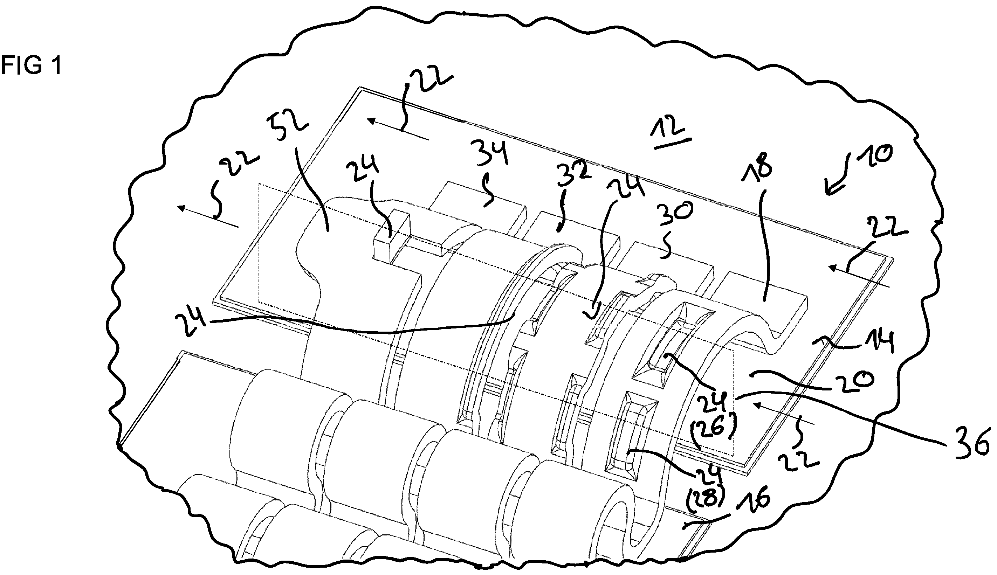

Es sei zunächst auf FIG 1 verwiesen, die ein mittels Kühlflüssigkeit gekühltes elektronisches Bauelement 10 zeigt.

Das flüssigkeitsgekühlte Bauelement 10 weist ein Substrat 12, wie bspw. eine Leiterplatte auf. Das Bauelement 10 weist einen ersten Halbleiterbauelementabschnitt 14 auf, der auf dem Substrat 12 befestigt ist. Das Bauelement 10 weist einen zweiten Halbleiterbauelementabschnitt 16 auf, der auf dem Substrat 12 befestigt ist. Die beiden Halbleiterbauelementabschnitte 14, 16 sind voneinander beabstandet angeordnet und gehören im konkreten Beispiel von FIG 1 zu zwei separaten Halbleiterbauteilen, wie beispielsweise zu zwei MOSFETS. In anderen nicht gezeigten Ausführungsformen können die zwei Halbleiterbauelementabschnitte 14, 16 aber auch zwei separate und voneinander beabstandete Abschnitte bzw. Bereiche von ein und demselben Halbleiterbauteil sein.

Das Bauelement 10 weist ferner ein Verbindungselement 18 auf, das die beiden Halbleiterbauelementabschnitte 14, 16 elektrisch miteinander verbindet. Im konkreten Beispiel von FIG 1 erstreckt sich das Verbindungselement 18 bogenförmig zwischen den beiden Halbleiterbauelementabschnitten 14, 16 und bildet zusammen mit den Halbleiterbauelementabschnitten 14, 16 und dem Substrat 12 einen Kühlflüssigkeitskanal 20.

Zur Kühlung der Halbleiterbauelementabschnitt 14, 16 ist das Bauelement 10 in Kühlflüssigkeit eingetaucht. Die Kühlflüssigkeit ist bspw. dielektrisch und wird von einer Kühlflüssigkeitsversorgungseinrichtung bereitgestellt, die eine Hauptströmungsrichtung der Kühlflüssigkeit vorgibt. Die Hauptströmungsrichtung der Kühlflüssigkeit ist in FIG 1 schematisch durch die Pfeile 22 dargestellt. Die Hauptströmungsrichtung 22 gibt an, in welche Richtung die Kühlflüssigkeit im Wesentlichen über die beiden Halbleiterbauelementabschnitte 14, 16 strömt. Die Kühlflüssigkeit hat die Aufgabe, Wärme, die beim Betrieb der Halbleiterbauelementabschnitte 14, 16 erzeugt wird, abzutransportieren. Indem die Kühlflüssigkeit in Hauptströmungsrichtung 22 über die Halbleiterbauelementabschnitt 14, 16 strömt, kann die Kühlflüssigkeit Wärme aufnehmen und diese Wärme abtransportieren.

Im erfindungsgemäßen flüssigkeitsgekühlten elektronischen Bauelement 10 weist das Verbindungselement 18 nunmehr ein sogenanntes Strömungsstörungselement 24 auf. Das Strömungsstörungselement 24 erstreckt sich derart, dass es zumindest teilweise die Hauptströmungsrichtung 22 der Kühlflüssigkeit kreuzt. Das Strömungsstörungselement 24 ist im konkreten Beispiel als Delle im Verbindungselement 18 ausgebildet. Mit anderen Worten wird das Strömungsstörungselement 24 durch ein mechanisches Umformen, in diesem Fall ein Eindrücken von Bereichen des Verbindungselements 18 gebildet. Das Strömungsstörungselement 24 hat die Aufgabe, die Strömung der Kühlflüssigkeit zu stören bzw. zu beeinflussen. Indem das Strömungsstörungselement 24 die Hauptströmungsrichtung 22 kreuzt wird das Strömungsstörungselement 24 den Teil der Kühlflüssigkeit, der durch den Kühlflüssigkeitskanal 20 strömt, in eine bevorzugte Richtung lenken bzw. führen. Zudem wird das Strömungsstörungselement 24 aber auch eine Turbulenz der Strömung der Kühlflüssigkeit zumindest lokal im Bereich des Strömungsstörungselements 24 erhöhen. Beide Effekte führen dazu, dass eine Wärmeübertragung von den Halbleiterbauelementabschnitten 14, 16 zur Kühlflüssigkeit erhöht wird und damit eine bessere Entwärmung bzw. Kühlung der Halbleiterbauelementabschnitte 14, 16 erfolgen kann.

Das Strömungsstörungselement 24 kann vielfältige Ausgestaltungen haben.

So weist das Strömungsstörungselement 24 im konkreten Beispiel von FIG 1 beispielsweise zwei Strömungsstörungsabschnitte 26, 28 auf. Diese Strömungsstörungsabschnitte 26, 28 sind am Verbindungselement 18 verteilt angeordnet und erstrecken sich über die bogenförmige Ausgestaltung des Verbindungselements 18. Im konkreten Beispiel von FIG 1 ist das Strömungsstörungselement 24 zudem in Hauptströmungsrichtung 22 der Kühlflüssigkeit betrachtet mittig angeordnet.

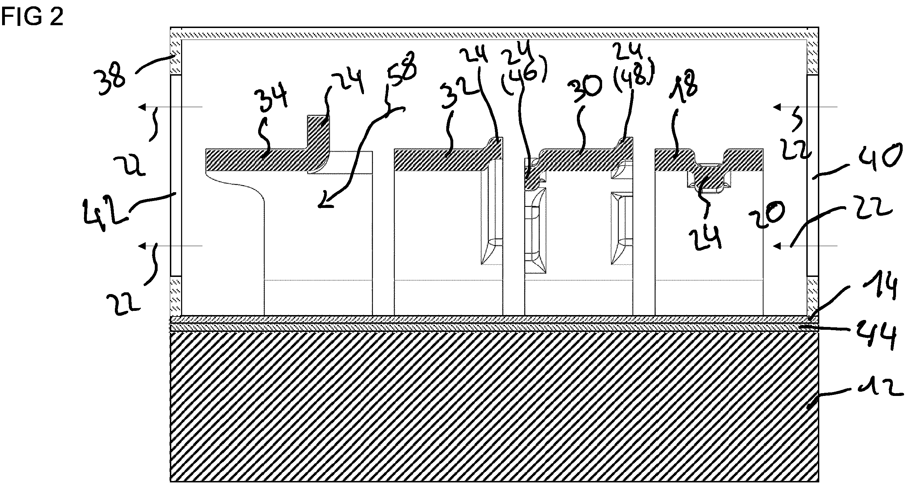

Um weitere Ausgestaltungen des Strömungsstörungselements 24 zu verdeutlichen, weist im konkreten Beispiel von FIG 1 das Bauelement 10 neben dem (ersten) Verbindungselement 18 weitere Verbindungselemente 30, 32, 34 auf, die ihrerseits weitere Strömungsstörungselemente 24 aufweisen. Die konkrete Ausgestaltung der Strömungsstörungselemente 24 wird näher in Zusammenhang mit FIG 2 erläutert. Letztlich ist es aber auch möglich, dass eine oder mehrere der Ausgestaltungen der Strömungsstörungselemente 24 an nur einem der Verbindungselement 18, 30 bis 34 ausgebildet ist.

Im konkreten Beispiel von FIG 1 sind die jeweiligen Verbindungselemente 18, 30 bis 34 jeweils derart zueinander beabstandet angeordnet, dass sie den bereits beschriebenen Kühlflüssigkeitskanal 20 in Richtung der Hauptströmungsrichtung 22 weiterbilden. Somit strömt die Kühlflüssigkeit zunächst am Strömungsstörungselement 24 des Verbindungselements 18 vorbei, anschließend am Strömungsstörungselement 24 des Verbindungselements 30, anschließend am Strömungsstörungselement 24 des Verbindungselements 32 und anschließend am Strömungsstörungselement 24 des Verbindungselements 34 etc.

Beliebige weitere Kombinationen von Strömungsstörungselementen 24 und eine beliebige andere Anzahl an Verbindungselementen im Bauelement 10 sind denkbar.

Es sei nun auf FIG 2 verwiesen, die eine Schnittansicht entlang der Schnittebene 36 von FIG 1 darstellt.

In FIG 2 ist wiederum die Hauptströmungsrichtung der Kühlflüssigkeit durch die Pfeile 22 angedeutet. Ebenso ist in FIG 2 schematisch ein Gehäuse 38 angedeutet, das eine Eingangsöffnung 40, durch die von der Kühlflüssigkeitsversorgungseinrichtung bereitgestellte Kühlflüssigkeit eintritt, und eine Ausgangsöffnung 42, durch die die erwärmte Kühlflüssigkeit austritt, aufweist. In FIG 2 ist ebenfalls das bereits angesprochene Substrat 12 gezeigt, wie auch der Halbleiterbauelementabschnitt 14, der mittels einer angedeuteten Befestigungsschicht 44 auf dem Substrat 12 befestigt ist. Ebenso sind in FIG 2 die Verbindungselemente 18, 30 bis 34 gezeigt.

Wie in FIG 2 gut zu erkennen ist, kreuzt jedes der Strömungsstörungselemente 24 der Verbindungselemente 18, 30 bis 34 die Hauptströmungsrichtung 22 der Kühlflüssigkeit. Das Strömungsstörungselement 24 des Verbindungselements 18 ragt beispielsweise in den Kühlflüssigkeitskanal 20 hinein. Zudem ist das Strömungsstörungselement 24 des Verbindungselements 18 in Hauptströmungsrichtung 22 der Kühlflüssigkeit betrachtet mittig am Verbindungselement 18 angeordnet. Das Strömungsstörungselement 24 des Verbindungselements 30 ist in Hauptströmungsrichtung 22 der Kühlflüssigkeit betrachtet hingegen in Randbereichen des Verbindungselements 30 angeordnet. Zudem ist das Strömungsstörungselement 24 des Verbindungselements 30 aus zwei Strömungsstörungsabschnitten 46, 48 gebildet, von denen ein erster Strömungsstörungsabschnitt 46 in den Kühlflüssigkeitskanal 20 hineinragt und ein zweiter Strömungsstörungsabschnitt 48 aus dem Kühlflüssigkeitskanal 20 herausragt. Das Strömungsführungselement 24 des Verbindungselements 32 besteht wiederum nur aus einem einzigen Strömungsstörungsabschnitt, der sich im Wesentlichen auch noch über den gesamten rechten Randbereich des Verbindungselements 32 erstreckt. Benachbarte Strömungsstörungselemente 24 kreuzen zudem die Hauptströmungsrichtung 22 der Kühlflüssigkeit in entgegengesetzte Richtungen. So ragt der erste Strömungsstörungsabschnitt 46 des Strömungsstörungselement 24 des Verbindungselements 30 in den Kühlflüssigkeitskanal 20 hinein, während das Strömungsstörungselement 24 am benachbarten Verbindungselement 32 aus dem Kühlflüssigkeitskanal 20 herausragt.

Die Strömungsstörungselemente 24 an den Verbindungselementen 18, 30 und 32 sind jeweils durch Umformen der Verbindungselemente 18, 30, 32 bzw. durch Eindrücken von Abschnitten der Verbindungselemente 18, 30, 32 gebildet.

Im Gegensatz dazu ist das Strömungsstörungselement 24 am Verbindungselement 34 durch einen lokalen Schnitt am Verbindungselement 34 und durch anschließendes Umbiegen des ausgeschnittenen Teils entstanden. Das Strömungsstörungselement 24 am Verbindungselement 34 ragt wiederum aus dem Kühlflüssigkeitskanal 20 heraus und kreuzt die Hauptströmungsrichtung 22 der Kühlflüssigkeit. Zudem ragt es derart aus dem Kühlflüssigkeitskanal 20, dass ein Teil der Kühlflüssigkeit, der außerhalb des Kühlflüssigkeitskanals 20 vorbeiströmt, in den Kühlflüssigkeitskanal 20 hinein gelenkt wird. Dies ist schematisch durch den Pfeil 58 angedeutet. Die Ausrichtung des Strömungsstörungselements 24 am Verbindungselement 34 ermöglicht ein gezieltes Führen von Kühlflüssigkeit in den Kühlflüssigkeitskanal 20 hinein. Dadurch kann dem Kühlflüssigkeitskanal 20 mehr Kühlflüssigkeit zugeführt werden, wodurch der Wärmetransport bzw. die Wärmeabfuhr verbessert wird.

Wie in Zusammenhang mit FIG 1 zu erkennen ist, weist das Verbindungselement 34 im Bereich des Strömungsstörungselements 24 eine lokale Verbreiterung 52 auf. Die lokale Verbreiterung dient dazu, die Stromtragfähigkeit des Verbindungselements 34 trotz der Ausnehmung im Verbindungselement 34 zu erhalten.

Vielfältige weitere Kombinationen von Ausgestaltungen der Strömungsstörungselemente 24 von einem oder mehreren der Verbindungselemente 18, 30 bis 34 sind denkbar.

In jedem Fall sind die Strömungsstörungselemente 24 direkt an den Verbindungselementen 18, 30 bis 34 ausgebildet. Die konkrete Anordnung und Ausgestaltung eines jeweiligen Strömungsstörungselements 24 an einem jeweiligen Verbindungselement 18, 30 bis 34 hängt vom jeweiligen konkreten Anwendungsfall ab.

## Patentansprüche

1. Flüssigkeitsgekühltes elektronisches Bauelement (10) aufweisend:
- ein Substrat (12),
- einen auf dem Substrat (12) angebrachten ersten Halbleiterbauelementabschnitt (14),
- einen auf dem Substrat (12) angebrachten zweiten Halbleiterbauelementabschnitt (16), der vom ersten Halbleiterbauelementabschnitt (14) beabstandet angeordnet ist,
- eine Kühlflüssigkeitsversorgungseinrichtung zur Versorgung des ersten Halbleiterbauelementabschnitts (14) und des zweiten Halbleiterbauelementabschnitts (16) mit Kühlflüssigkeit, wobei die Kühlflüssigkeitsversorgungseinrichtung eine Hauptströmungsrichtung (22) der Kühlflüssigkeit vorgibt,
- ein Verbindungselement (18, 30-34), das den ersten Halbleiterbauelementabschnitt (14) und den zweiten Halbleiterbauelementabschnitt (16) elektrisch miteinander verbindet, charakterisiert durch
- ein am Verbindungselement (18, 30-34) ausgebildetes Strömungsstörungselement (24), das sich vom Verbindungselement (18, 30-34) derart erstreckt, dass das Strömungsstörungselement (24) die Hauptströmungsrichtung (22) der Kühlflüssigkeit kreuzt.

2. Bauelement (10) nach Anspruch 1, wobei das Strömungsstörungselement (24) mit dem Verbindungselement (18, 30-34) einstückig ausgebildet ist.

3. Bauelement (10) nach Anspruch 2, wobei das Strömungsstörungselement (24) durch Umformen des Verbindungselements (18, 30-34) gebildet ist.

4. Bauelement (10) nach Anspruch 3, wobei das Verbindungselement (34) im Bereich des Strömungsstörungselements (24) verbreitert ausgebildet ist zur Gewährleistung einer vom Verbindungselement (34) zu erfüllenden, vorbestimmten Stromtragfähigkeit.

5. Bauelement (10) nach einem der vorhergehenden Ansprüche, wobei das Verbindungselement (18, 30-34) zusammen mit dem ersten Halbleiterbauelementabschnitt (14) und dem zweiten Halbleiterbauelementabschnitt (16) einen Kühlflüssigkeitskanal (20) bildet, der zum Führen zumindest eines Teils der zur Versorgung des ersten und zweiten Halbleiterbauelementabschnitts (14, 16) bereitgestellten Kühlflüssigkeit dient, und wobei das Strömungsstörungselement (24) zumindest teilweise in den Kühlflüssigkeitskanal (20) hineinragt.

6. Bauelement (10) nach einem der Ansprüche 1 bis 4, wobei das Verbindungselement (24) zusammen mit dem ersten Halbleiterbauelementabschnitt (14) und dem zweiten Halbleiterbauelementabschnitt (16) einen Kühlflüssigkeitskanal (20) bildet, der zum Führen zumindest eines Teils der zur Versorgung des ersten und zweiten Halbleiterbauelementabschnitts (14, 16) bereitgestellten Kühlflüssigkeit dient, und wobei das Strömungsstörungselement (24) zumindest teilweise aus dem Kühlflüssigkeitskanal (20) herausragt.

7. Bauelement (10) nach Anspruch 6, wobei das Strömungsstörungselement (24) zumindest teilweise derart aus dem Kühlflüssigkeitskanal (20) herausragt, dass eine außerhalb des Kühlflüssigkeitskanals (20) vorhandene Kühlflüssigkeitsströmung zumindest teilweise in den Kühlflüssigkeitskanal (20) hineingelenkt wird.

8. Bauelement (10) nach einem der vorhergehenden Ansprüche, wobei sich das Verbindungselement (18, 30-34) zwischen dem ersten Halbleiterbauelementabschnitt (14) und dem zweiten Halbleiterbauelementabschnitt (16) bogenförmig erstreckt und das Strömungsstörungselement (24) am Verbindungselement (18, 30-34) mittig zwischen dem ersten Halbleiterbauelementabschnitt (14) und dem zweiten Halbleiterbauelementabschnitt (16) angeordnet ist.

9. Bauelement (10) nach einem der vorhergehenden Ansprüche, wobei das Strömungsstörungselement (24) in Richtung der Hauptströmungsrichtung (22) der Kühlflüssigkeit betrachtet mittig am Verbindungselement (18, 30-34) angeordnet ist.

10. Bauelement (10) nach einem der Ansprüche 1 bis 8, wobei das Strömungsstörungselement (24) in Richtung der Hauptströmungsrichtung (22) der Kühlflüssigkeit betrachtet an seitlichen Randbereichen des Verbindungselements (18, 30-34) angeordnet ist.

11. Bauelement (10) nach einem der vorhergehenden Ansprüche, wobei das Strömungsstörungselement (24) aus mehreren Strömungsstörungsabschnitten (26, 28; 46, 48) besteht, die untereinander beabstandet und am Verbindungselement (18; 30) verteilt angeordnet sind.

12. Bauelement (10) nach einem der vorhergehenden Ansprüche, ferner aufweisend:
- mindestens ein weiteres Verbindungselement (30-34), das den ersten Halbleiterbauelementabschnitt (14) und den zweiten Halbleiterbauelementabschnitt (16) elektrisch miteinander verbindet und in Hauptströmungsrichtung (22) der Kühlflüssigkeit betrachtet benachbart zum ersten Verbindungselement (18) angeordnet ist, wobei das weitere Verbindungselement (30-34) ein weiteres Strömungsstörungselement (24) aufweist, das sich vom weiteren Verbindungselement (30-34) derart erstreckt, dass auch das weitere Strömungsstörungselement (24) die Hauptströmungsrichtung (22) der Kühlflüssigkeit kreuzt.

13. Bauelement (10) nach Anspruch 12, wobei das Strömungsstörungselement (24) des ersten Verbindungselements und das weitere Strömungsstörungselement (24) des weiteren Verbindungselements (30-34) die Hauptströmungsrichtung (22) der Kühlflüssigkeit in entgegengesetzte Richtungen kreuzen.

## Claims

1. Liquid-cooled electronic component (10) comprising:
- a substrate (12),
- a first semiconductor component portion (14) mounted on the substrate (12),
- a second semiconductor component portion (16) mounted on the substrate (12) and arranged at a distance from the first semiconductor component portion (14),
- a cooling liquid supply device for supplying cooling liquid to the first semiconductor component portion (14) and the second semiconductor component portion (16), wherein the cooling liquid supply device specifies a main flow direction (22) of the cooling liquid,
- a connecting element (18, 30-34), which electrically connects the first semiconductor component portion (14) and the second semiconductor component portion (16) to each other, **characterized by**
- a flow disruption element (24) formed on the connecting element (18, 30-34) and extending from the connecting element (18, 30-34) in such a way that the flow disruption element (24) crosses the main flow direction (22) of the cooling liquid.

2. Component (10) according to Claim 1, wherein the flow disruption element (24) is formed in one piece with the connecting element (18, 30-34).

3. Component (10) according to Claim 2, wherein the flow disruption element (24) is formed by reshaping the connecting element (18, 30-34).

4. Component (10) according to Claim 3, wherein the connecting element (34) is widened in the region of the flow disruption element (24) in order to ensure a predetermined current-carrying capacity to be fulfilled by the connecting element (34).

5. Component (10) according to any of the preceding claims, wherein the connecting element (18, 30-34) together with the first semiconductor component portion (14) and the second semiconductor component portion (16) forms a cooling liquid channel (20), which serves to guide at least some of the cooling liquid provided for supplying the first and the second semiconductor component portion (14, 16), and wherein the flow disruption element (24) at least partially protrudes into the cooling liquid channel (20).

6. Component (10) according to any of Claims 1 to 4, wherein the connecting element (24) together with the first semiconductor component portion (14) and the second semiconductor component portion (16) forms a cooling liquid channel (20), which serves to guide at least some of the cooling liquid provided for supplying the first and the second semiconductor component portion (14, 16), and wherein the flow disruption element (24) at least partially protrudes from the cooling liquid channel (20).

7. Component (10) according to Claim 6, wherein the flow disruption element (24) at least partially protrudes from the cooling liquid channel (20) in such a way that a cooling liquid flow present outside the cooling liquid channel (20) is at least partially deflected into the cooling liquid channel (20).

8. Component (10) according to any of the preceding claims, wherein the connecting element (18, 30-34) extends in the form of an arc between the first semiconductor component portion (14) and the second semiconductor component portion (16) and the flow disruption element (24) is arranged on the connecting element (18, 30-34) centrally between the first semiconductor component portion (14) and the second semiconductor component portion (16).

9. Component (10) according to any of the preceding claims, wherein the flow disruption element (24) is arranged centrally on the connecting element (18, 30-34) as viewed in the direction of the main flow direction (22) of the cooling liquid.

10. Component (10) according to any of Claims 1 to 8, wherein the flow disruption element (24) is arranged at the lateral edge regions of the connecting element (18, 30-34) as viewed in the direction of the main flow direction (22) of the cooling liquid.

11. Component (10) according to any of the preceding claims, wherein the flow disruption element (24) consists of a plurality of flow disruption portions (26, 28; 46, 48) which are at arranged a distance from each other and distributed over the connecting element (18; 30).

12. Component (10) according to any of the preceding claims, further comprising:
- at least one further connecting element (30-34), which electrically connects the first semiconductor component portion (14) and the second semiconductor component portion (16) to each other and is arranged adjacent to the first connecting element (18) as viewed in the main flow direction (22) of the cooling liquid, wherein the further connecting element (30-34) has a further flow disruption element (24), which extends from the further connecting element (30-34) in such a way that the further flow disruption element (24) also crosses the main flow direction (22) of the cooling liquid.

13. Component (10) according to Claim 12, wherein the flow disruption element (24) of the first connecting element and the further flow disruption element (24) of the further connecting element (30-34) cross the main flow direction (22) of the cooling liquid in opposite directions.

## Revendications

1. Composant électronique refroidi par liquide (10) comportant :
- un substrat (12),
- une première partie de composant semi-conducteur (14) montée sur le substrat (12),
- une deuxième partie de composant semi-conducteur (16) montée sur le substrat (12), qui est disposée à distance de la première partie de composant semi-conducteur (14),
- un dispositif d'alimentation en liquide de refroidissement pour alimenter la première partie de composant semi-conducteur (14) et la deuxième partie de composant semi-conducteur (16) en liquide de refroidissement, le dispositif d'alimentation en liquide de refroidissement prédéfinissant une direction d'écoulement principale (22) du liquide de refroidissement,
- un élément de liaison (18, 30-34) qui relie électriquement l'une à l'autre la première partie de composant semi-conducteur (14) et la deuxième partie de composant semi-conducteur (16), **caractérisé par**
- un élément perturbateur d'écoulement (24) formé sur l'élément de liaison (18, 30-34) et s'étendant à partir de l'élément de liaison (18, 30-34) de telle sorte que l'élément perturbateur d'écoulement (24) croise la direction d'écoulement principale (22) du liquide de refroidissement.

2. Composant (10) selon la revendication 1, dans lequel l'élément perturbateur d'écoulement (24) est formé d'une seule pièce avec l'élément de liaison (18, 30-34).

3. Composant (10) selon la revendication 2, dans lequel l'élément perturbateur d'écoulement (24) est formé par façonnage de l'élément de liaison (18, 30-34).

4. Composant (10) selon la revendication 3, dans lequel l'élément de liaison (34) est réalisé de manière à s'élargir dans la zone de l'élément perturbateur d'écoulement (24) afin de garantir une capacité de transport de courant prédéterminée devant être satisfaite par l'élément de liaison (34).

5. Composant (10) selon l'une quelconque des revendications précédentes, dans lequel l'élément de liaison (18, 30-34) forme avec la première partie de composant semi-conducteur (14) et la deuxième partie de composant semi-conducteur (16) un canal de liquide de refroidissement (20) qui sert à guider au moins une partie du liquide de refroidissement prévu pour l'alimentation des première et deuxième parties de composant semi-conducteur (14, 16), et l'élément perturbateur d'écoulement (24) faisant saillie au moins partiellement dans le canal de liquide de refroidissement (20).

6. Composant (10) selon l'une quelconque des revendications 1 à 4, dans lequel l'élément de liaison (24) forme avec la première partie de composant semi-conducteur (14) et la deuxième partie de composant semi-conducteur (16) un canal de liquide de refroidissement (20) qui sert à guider au moins une partie du liquide de refroidissement prévu pour l'alimentation des première et deuxième parties de composant semi-conducteur (14, 16), et l'élément perturbateur d'écoulement (24) faisant saillie au moins partiellement hors du canal de liquide de refroidissement (20).

7. Composant (10) selon la revendication 6, dans lequel l'élément perturbateur d'écoulement (24) fait saillie au moins partiellement hors du canal de liquide de refroidissement (20) de telle sorte qu'un écoulement de liquide de refroidissement présent à l'extérieur du canal de liquide de refroidissement (20) est dévié au moins partiellement dans le canal de liquide de refroidissement (20).

8. Composant (10) selon l'une quelconque des revendications précédentes, dans lequel l'élément de liaison (18, 30-34) s'étend en arc de cercle entre la première partie de composant semi-conducteur (14) et la deuxième partie de composant semi-conducteur (16) et l'élément perturbateur d'écoulement (24) est disposé sur l'élément de liaison (18, 30-34) en position centrale entre la première partie de composant semi-conducteur (14) et la deuxième partie de composant semi-conducteur (16).

9. Composant (10) selon l'une quelconque des revendications précédentes, dans lequel l'élément perturbateur d'écoulement (24) est disposé au centre de l'élément de liaison (18, 30-34) lorsqu'il est observé suivant la direction d'écoulement principale (22) du liquide de refroidissement.

10. Composant (10) selon l'une quelconque des revendications 1 à 8, dans lequel l'élément perturbateur d'écoulement (24) est disposé sur des zones de bord latérales de l'élément de liaison (18, 30-34) lorsqu'il est observé suivant la direction d'écoulement principale (22) du liquide de refroidissement.

11. Composant (10) selon l'une quelconque des revendications précédentes, dans lequel l'élément perturbateur d'écoulement (24) est constitué de plusieurs parties perturbatrices d'écoulement (26, 28 ; 46, 48) qui sont disposées à distance les unes des autres et réparties sur l'élément de liaison (18 ; 30).

12. Composant (10) selon l'une quelconque des revendications précédentes, comportant en outre :
- au moins un autre élément de liaison (30-34) qui relie électriquement l'une à l'autre la première partie de composant semi-conducteur (14) et la deuxième partie de composant semi-conducteur (16) et qui, lorsqu'il est observé dans la direction d'écoulement principale (22) du liquide de refroidissement, est disposé à proximité du premier élément de liaison (18), l'autre élément de liaison (30-34) comportant un autre élément perturbateur d'écoulement (24), qui s'étend à partir de l'autre élément de liaison (30-34) de telle sorte que l'autre élément perturbateur d'écoulement (24) croise également la direction d'écoulement principale (22) du liquide de refroidissement.

13. Composant (10) selon la revendication 12, dans lequel l'élément perturbateur d'écoulement (24) du premier élément de raccordement et l'autre élément perturbateur d'écoulement (24) de l'autre élément de raccordement (30-34) croisent la direction d'écoulement principale (22) du liquide de refroidissement dans des directions opposées.
